# EUROPÄISCHE PATENTSCHRIFT

(11) **EP 0 771 492 B1**
(45) Veröffentlichungstag und Bekanntmachung des Hinweises auf die Patenterteilung: **23.09.1998**
(21) Anmeldenummer: 95924184.5
(22) Anmeldetag: 10.07.1995
(51) Int. Cl.: H03K 17/082, H05B 41/392

(54) **REGELVERSTÄRKER ZUR STEUERUNG EINER HOCHOHMIGEN NIEDERSPANNUNGSQUELLE**
SERVO-AMPLIFIER FOR CONTROLLING A HIGH-OHMIC LOW-VOLTAGE SOURCE
AMPLIFICATEUR DE REGLAGE POUR MODULER UNE SOURCE BASSE TENSION A HAUTE IMPEDANCE

(30) Priorität: 21.07.1994 DE 4425901
(43) Veröffentlichungstag der Anmeldung: 07.05.1997
(73) Patentinhaber: SIEMENS AKTIENGESELLSCHAFT, 80333 München (DE)
(72) Erfinder: STIEGLBAUER, Walter, D-94234 Viechtach (DE); FICHTNER, Norbert, D-93073 Neutraubling (DE); ZIERHUT, Hermann, D-93073 Neutraubling (DE)
(86) Internationale Anmeldenummer: DE9500901
(87) Internationale Veröffentlichungsnummer: WO9603806

(56) Entgegenhaltungen:
- DE-A- 3 325 361
- DE-A- 3 433 538
- FR-A- 2 615 676
- US-A- 4 672 327
- US-A- 5 001 386
- IBM TECHNICAL DISCLOSURE BULLETIN, Bd. 35, Nr. 7, Dezember 1992 NEW YORK US, Seiten 28-29, XP 000332933 'COMBINED DIMMER AND VOLTAGE REGULATOR CIRCUIT FOR FLUORESCENT LAMP INVERTER'

## Beschreibung

Die Erfindung bezieht sich auf einen Regelverstärker zur Steuerung einer Niederspannungsquelle mit Innenwiderstand, welche an zwei Ausgangsklemmen angeschlossen ist und mittels Impedanzanderung zwischen zwei Grenzwerten steuerbar ist, im einzelnen nach Gattungsbegriff von Patentanspruch 1.

Die Eingangsseite weist eine galvanische Trennung durch einen Trenntransformator auf und sekundärseitig ist eine Betriebsspannungsversorgung für den Regelverstärker vorgesehen.

Für Regelverstärker zur Steuerung einer Niederspannungsquelle gibt es die verschiedenartigsten Einsatzgebiete. Beispielsweise benötigt man einen derartigen Regelverstärker, um dimmbare elektronische Vorschaltgeräte, sogenannte EVG's anzusteuern. In diesem Zusammenhang spricht man auch von hochohmigen Niederspannungsquellen. Über einen Bus der Gebäudesystemtechnik wird beispielsweise ein digitales Signal für einen Dimmvorgang über einen Busankoppler und den Regelverstärker einem Schalt-Dimm-Aktor zugeführt. Der Schalt-Dimm-Aktor wandelt das digitale Signal in ein pulsweitenmoduliertes Signal um und der Regelverstärker bereitet hieraus ein konstant anliegendes Analogsignal auf, das einem dimmbaren elektronischen Vorschaltgerät zugeführt wird, um bei einer Leuchtstofflampe einen bestimmten Dimmzustand zu erzielen. Die Stellsignale für das Dimmen können statt über einen Bus auch über eine Infrarotsteuerung zugeührt werden. Man benötigt hierbei Regelverstärker, die zwischen zwei Grenzwerten des pulsweitenmodulierten Signals gesteuert werden.

Man benötigt also einen Verstärker, so daß eine Spannungsquelle mit Innenwiderstand im Bereich von wenigen Volt durch Impedanzänderung eingestellt wird. Eine derartige Spannungsquelle ist bei dimmbaren EVG's vorhanden. Darüber hinaus soll eine galvanische Trennung zwischen dem Steuersignal und dem anzusteuernden Verstärker bestehen.

Bei einer bekannten Regelschaltung werden die Steuerimpulse potentialgetrennt zugeführt (FR-A-2 615 676). Hierbei werden Steuersignal und Betriebsspannung zur Steuerung eines Operationsverstärkers über einen Übertrager zugeführt. Die Sekundärwicklung des Übertragers dient zum Bereitstellen der Betriebsspannung. Die Information ist hierbei in der Amplitude enthalten.

Der Erfindung liegt die Aufgabe zugrunde, einen Regelverstärker zu entwickeln, der aus einem pulsweitenmodulierten Signal ein konstant anliegendes analoges Signal am Ausgang bereitstellt und der hohe Isolationsanforderungen erfüllt, wie sie beim EIBA-Bus der European Installation Bus Association beispielsweise bestehen.

Die Lösung der geschilderten Aufgabe erfolgt nach der Erfindung durch einen Regelverstärker nach Patentanspruch 1. Hierbei ist an einem Trenntransformator zur galvanischen Trennung an einer Sekundärwicklung eine Schaltung zur Mittelwertbildung aus dem pulsweitenmodulierten Steuersignal zur Abbildung des Steuersignals angeschlossen. Die Sekundärwicklung kann auch in eine Spannungsvervielfacherschaltung zum Bereitstellen der Betriebsspannung für den Regelverstärker einbezogen sein. Der Regelverstärker kann bei Anwendungsfällen für den EIBA-Bus dafür ausgelegt sein, eingangsseitige Steuersignale in der Größenordnung von ein bis zehn Volt zu verarbeiten. Vorteilhafterweise kann der Regelverstärker in seiner Endstufe mit einem Feldeffekttransistor, FET, arbeiten, dessen Sperrspannung mindestens 400 Volt aufweist. Besonders vorteilhaft ist eine Sperrspannung von 700 Volt, um Betriebsstörungen zu vermeiden. Der Regelverstärker als Bestandteil eines Schalt-Dimm-Aktors ausgeführt sein.

Nach einer Weiterbildung ist der Regelverstärker durch eine Maßnahme nach Anspruch 3 gegen Überspannungen geschützt. Der Feldeffekttransistor der Endstufe wird dabei durch eine Rückkoppelschaltung derart angesteuert, daß er bei Überschreiten der nominalen Ausgangsspannung infolge einer ausgangsseitig dem Regelverstärker zugeführten Spannung in den Sperrzustand überführt wird. Das erfolgt beispielsweise dann, wenn statt der hochohmigen Niederspannungsquelle in der Größenordnung von 10 Volt beispielsweise eine Installationsnetzspannung von 230 Volt angelegt wird. Durch einen Widerstand und bzw. oder eine Drossel in der Source-Leitung des FET ist es leicht möglich, den maximal zulässigen Drainstrom im Fall einer Falsch-Verdrahtung bzw. eines Falschanschlusses einzustellen. Der Regelverstärker ist dann gegen Falschanschluß geschützt.

Es ist vorteilhaft, den Feldeffekttransistor gegen die Folgen einer Überschreitung seiner zulässigen Sperrspannung zu schützen. Hierzu kann der Feldeffekttransistor durch eine Rückkoppelschaltung derart angesteuert sein, daß bei eingangsseitig anliegenden Überspannungen, die zur Überschreitung der zulässigen Sperrspannung des Feldeffekttransistors führen, dieser kurzzeitig leitend gesteuert wird. Einfacher und vorteilhafter ist es, den Feldeffekttransistor avalanchefest auszuwählen.

Es ist günstig, dem Feldeffekttransistor einen Widerstand, sei es einen ohmschen oder einen induktiven Widerstand, in Serie zu schalten, um eine Strombegrenzung zu erzielen, bis der Feldeffekttranssistor in den Sperrzustand überführt ist.

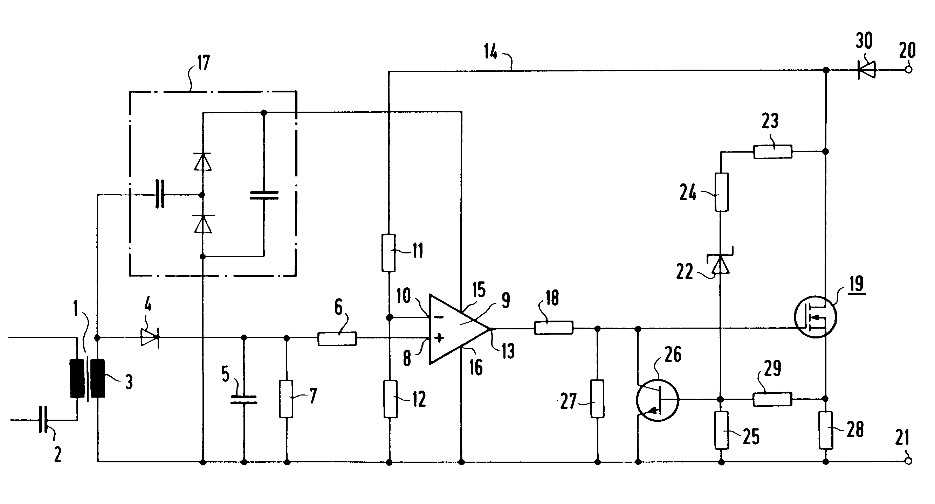

Die Erfindung soll nun anhand eines in der Zeichnung grob schematisch wiedergegebenen Ausführungsbeispiels näher erläutert werden:

Der Regelverstärker weist eingangsseitig zur galvanischen Trennung einen Trenntransformator 1 auf, dem vorteilhafterweise zur Entkopplung gegen Gleichspannung ein Kondensator 2 zur Trennung gegen Gleichspannung in Serie geschaltet ist. An der Sekundärwicklung 3 des Trenntransformators 1 ist eine Schaltung zur Mittelwertbildung aus dem pulsweitenmodulierten Steuersignal, das eingangsseitig ansteht, angeschlossen. Die Mittelwertbildung erfolgt im Ausführungsbeispiel durch eine Diode 4 und eine Kapazität 5 sowie die Widerstände 6 und 7. Der gebildete Mittelwert aus dem pulsweitenmodulierten Signal steht am Eingang 8 eines Operationsverstärkers 9 als Sollwert an. Ein jeweiliger Istwert wird dem negativen Steuereingang 10 des Operationsverstärkers 9 vom Spannungsteiler mit den Widerständen 11 und 12 zugeführt, wobei diese in einer Rückkopplungsleitung 14 liegen. Der Operationsverstärker 9 steuert über seinen Ausgang 13 den FET 19 derart, daß Istwert und Sollwert einander angeglichen werden. Mit Mittelwertbildung sollen hier auch andere, im Ergebnis gleichartig wirkende Schaltungen eingeschlossen sein.

Die Betriebsspannungseingänge 15 und 16 des Operationsverstärkers 9 erhalten ihre Betriebsspannung von einer Spannungsvervielfacherschaltung 17, im Ausführungsbeispiel eine Spannungsverdopplerschaltung.

Am Ausgang 13 des Operationsverstärkers 9 ist im Ausführungsbeispiel über einen Schutzwiderstand 18 das Gate eines Feldeffekttransistors 19, auch als FET bezeichnet, angeschlossen. An den Ausgangsklemmen 20 und 21 steht dann ein konstantes vom FET gesteuertes analoges Signal, Spannung bzw. Strom, an. FET 19 ist durch eine Rückkoppelschaltung - mit den Bauelementen Zenerdiode 22, Widerstände 23, 24 und 25 sowie Transistor 26 - derart angesteuert, daß bei Überschreiten der nominalen Ausgangsspannung FET 19 in den Sperrzustand überführt wird. Wenn die Zenerdiode 22 durchlässig wird, zieht der Transistor 26 über seine Basis-Emitter-Strecke Strom, so daß er in den leitenden Zustand geführt wird und die Gate-Elektrode des FET 19 gegen Masse liegt. Solange der Transistor 26 keinen Strom zieht, sorgt der Widerstand 25 für sein stabiles Abschalten.

Wenn am FET 19 keine Steuerspannung anliegt, sorgt der Widerstand 27 dafür, daß das Gate auf Bezugspotential Masse liegt. Ein Widerstand 28 in der Sourceleitung des FET 19 sorgt insbesondere in Verbindung mit einem Widerstand 29 und dem Transistor 26 für eine Strombegrenzung durch den FET, bis er infolge seiner als Schutzschaltung wirkenden Rückkoppelschaltung mit den Widerständen 23, 24 und 25 sowie dem Transistor 26 vor Überlastung infolge Überspannungen geschützt werden kann. Der Transistor 26 erfüllt hier eine Doppelfunktion. Wenn beispielsweise am Widerstand 28 0,7 Volt, der Schwellspannung der Basis-Emitter-Strecke des Transistors 26, überschritten wird, führt der Transistor 26 das Gate des FET 19 näher an Bezugspotential Masse und führt den FET zunehmend in den Sperrzustand.

Eine Diode 30 schützt im Ausführungsbeispiel den Regelverstärker vor versehentlichem Anschluß an Installationsspannung, also beispielsweise 230 Volt, indem dem FET 19 nur für ihn verträgliche Gleichspannung zugeführt wird, die die zuvor geschilderten Schutzmechanismen in Gang setzt.

Dem Regelverstärker liegt das Prinzip zugrunde, seine Steuerspannung und seine Betriebsspannung aus einer eingangsseitig zugeführten Steuerspannung zu gewinnen.

Zum Schutz gegen Überschreiten der Sperrspannung des FET 19 ist es günstig, einen avalanchefesten FET auszuwählen. Andererseits kann der FET auch durch eine im Ausführungsbeispiel nicht wiedergegebene weitere Rückkoppelschaltung derart angesteuert werden, daß bei ausgangsseitig am Regelverstärker anliegenden Überspannungen, die zur Überschreitung der zulässigen Sperrspannung des FET führen würden, dieser kurzzeitig wieder leitend gesteuert wird.

## Patentansprüche

1. Regelverstärker zur Steuerung einer Niederspannungsquelle mit Innenwiderstand, welche an zwei Ausgangsklemmen (20,21) angeschlossen ist und mittels Impedanzänderung zwischen zwei Grenzwerten steuerbar ist, wobei die Eingangsseite eine galvanische Trennung durch einen Trenntransformator (1) aufweist, und wobei sekundärseitig eine Betriebsspannungsversorgung für den Regelverstärker vorgesehen ist,
**dadurch gekennzeichnet,**
daß an einer Sekundärwicklung (3) des Trenntransformators (1) eine Schaltung (4,5,6,7) zur Bildung eines Gleichspannungsmittelwertes aus einem pulsweitenmodulierten Steuersignal als Sollwert angeschlossen ist und daß eine Operationsverstärkerschaltung als Regelverstärker vorgesehen ist, der die Impedanzänderung bewirkt, wobei die dadurch an den Ausgangsklemmen (20,21) eingestellte Spannung als Istwert dient, wobei mittels der Operationsverstärkerschaltung die Impedanzänderung derart gesteuert ist, daß Ist- und Sollwert einander angeglichen werden, wobei die Sekundärwicklung (3) auch in die Schaltung zum Bereitstellen der Betriebsspannung für die Operationsverstärkerschaltung einbezogen ist, insbesondere in eine Spannungsvervielfacherschaltung (17).

2. Regelverstärker nach Anspruch 1,
**dadurch gekennzeichnet,**
daß für den Istwert in der Größenordnung von 1 bis 10 Volt die Operationsverstärkerschaltung als Endstufe einen Feldeffekttransistor (19), FET, aufweist, dessen Sperrspannung mindestens 400 Volt beträgt.

3. Regelverstärker nach Anspruch 2,
**dadurch gekennzeichnet,**
daß der FET durch eine Rückkopplungsschaltung (23, 24, 22, 25, 26, 27) derart angesteuert ist, daß er bei Überschreiten der nominalen Ausgangsspannung in den Sperrzustand überführt wird.

4. Regelverstärker nach Anspruch 2 oder 3,
**dadurch gekennzeichnet,**
daß der FET (19) durch eine Rückkoppelschaltung derart angesteuert ist, daß bei eingangsseitig am Regelverstärker anliegenden Überspannungen, die zur Überschreitung der zulässigen Sperrspannung des FET (19) führen würden, dieser kurzzeitig leitend gesteuert wird.

5. Regelverstärker nach Anspruch 2 oder 3,
**dadurch gekennzeichnet,**
daß der FET (19) avalanchefest ausgewählt ist.

6. Regelverstärker nach einem der Ansprüche 2 bis 5,
**dadurch gekennzeichnet,**
daß der FET (19) einen in seiner Sourceleitung eingeschalteten Widerstand (28) aufweist.

## Claims

1. Control amplifier for controlling a low-voltage source having internal impedance, which low-voltage source is connected to two output terminals (20, 21) and can be controlled between two limit values by means of impedance changing, the input side having DC isolation by means of an isolating transformer (1) and an operating voltage supply for the control amplifier being provided on the secondary side,
characterized
in that a circuit (4, 5, 6, 7) for forming a DC voltage mean value from a pulse-width-modulated control signal as a reference value is connected to a secondary winding (3) of the isolating transformer (1), and in that an operational amplifier circuit is provided as the control amplifier, which produces the impedance change, the voltage which is in consequence present at the output terminals (20, 21) being used as the actual value, the impedance change being controlled by means of the operational amplifier circuit in such a manner that the actual value and reference value are matched to one another, the secondary winding (3) also being included in the circuit for providing the operating voltage for the operational amplifier circuit, in particular in a voltage multiplier circuit (17).

2. Control amplifier according to Claim 1,
characterized
in that, for the actual value in the order of magnitude from 1 to 10 volts, the operational amplifier circuit has as the output stage a field-effect transistor (19), FET, whose off-state voltage is at least 400 volts.

3. Control amplifier according to Claim 2,
characterized
in that the FET is driven by a feedback circuit (23, 24, 22, 25, 26, 27) in such a manner that it is switched to the off-state if the nominal output voltage is exceeded.

4. Control amplifier according to Claim 2 or 3,
characterized
in that the FET (19) is driven by a feedback circuit in such a manner that, in the event of overvoltages being applied on the input side to the control amplifier which would lead to the permissible off-state voltage of the FET (19) being exceeded, this FET (19) is switched on briefly.

5. Control amplifier according to Claim 2 or 3,
characterized
in that FET (19) is selected to be avalanche-resistant.

6. Control amplifier according to one of Claims 2 to 5,
characterized
in that the FET (19) has a impedance (28) connected in its source line.

## Revendications

1. Amplificateur de réglage pour nodule une source basse tension avec résistance interne, qui est raccordée à deux bornes de sortie (20, 21) et qui peut être modulée entre deux valeurs limites au moyen d'une variation d'impédance, le côté entrée comportant une séparation électrique au moyen d'un transformateur d'isolement (1) et une alimentation en tension de service pour l'amplificateur de réglage étant prévue côté secondaire,
caractérisé par le fait que
un circuit (4, 5, 6, 7) de formation d'une valeur moyenne en tension continue à partir d'un signal de commande modulé en largeur d'impulsion est raccordé comme valeur de consigne à un enroulement secondaire (3) du transformateur d'isolement (1) et il est prévu un circuit amplificateur opérationnel comme amplificateur de réglage qui provoque la variation d'impédance, la tension ainsi réglée aux bornes de sortie (20, 21) servant comme valeur réelle, la variation d'impédance étant commandée au moyen du circuit amplificateur opérationnel de telle sorte que la valeur réelle et la valeur de consigne deviennent égales, l'enroulement secondaire (3) étant aussi inclus dans le circuit destiné à fournir la tension de service pour le circuit amplificateur opérationnel, notamment dans un circuit multiplicateur de tension (17).

2. Amplificateur de réglage selon la revendication 1,
caractérisé par le fait que,
pour la valeur réelle de l'ordre de 1 à 10 V, le circuit amplificateur opérationnel comporte comme étage final un transistor à effet de champ (19) dont la tension de blocage vaut au moins 400 V.

3. Amplificateur de réglage selon la revendication 2,
caractérisé par le fait que
le transistor à effet de champ est commandé par un circuit de rétroaction (23, 24, 22, 25, 26, 27) de telle sorte qu'il passe à l'état bloqué lors d'un dépassement de la valeur de sortie nominale.

4. Amplificateur de réglage selon la revendication 2 ou 3,
caractérisé par le fait que
le transistor à effet de champ (19) est commandé par un circuit de rétroaction de telle sorte qu'il repasse brièvement à l'état conducteur lors de surtensions appliquées côté entrée à l'amplificateur de réglage et pouvant conduire à un dépassement de la tension de blocage autorisée du transistor à effet de champ (19).

5. Amplificateur de réglage selon la revendication 2 ou 3,
caractérisé par le fait que
le transistor à effet de champ (19) est choisi résistant au claquage par avalanche.

6. Amplificateur de réglage selon l'une des revendications 2 à 5,
caractérisé par le fait que
le transistor à effet de champ (19) comporte une résistance (28) intercalée dans son conducteur de source.
